# NEUE EUROPÄISCHE PATENTSCHRIFT

(11) **EP 0 566 758 B2**
(45) Veröffentlichungstag und Bekanntmachung des Hinweises auf die Entscheidung über den Einspruch: **08.09.1999**
(45) Hinweis auf die Patenterteilung: 28.08.1996
(21) Anmeldenummer: 92106898.7
(22) Anmeldetag: 22.04.1992
(51) Int. Cl.: B60R 21/00, G01P 1/00, H05K 5/00

(54) **Sensoreinheit zur Steuerung eines Insassenschutzsystemes eines Fahrzeuges**
Detector unit for controlling a passenger protection system of a vehicle
Bloc détecteur de commande d'un système de protection de passager d'un véhicule

(43) Veröffentlichungstag der Anmeldung: 27.10.1993
(73) Patentinhaber: SIEMENS AKTIENGESELLSCHAFT, 80333 München (DE)
(72) Erfinder: Dirmeyer, Josef, Dipl.-Ing., W-8465 Bodenwöhr (DE); Mader, Gerhard, Dr. Dipl.-Phys., W-8401 Thalmassing (DE)

(56) Entgegenhaltungen:
- FR-A- 2 550 145
- GB-A- 2 084 330
- US-A- 3 383 565
- US-A- 4 577 496
- US-A- 5 096 427
- Zeitschrift 1141 Ingénieurs d'automobile (1982), No. 6, Seiten 69-77

## Beschreibung

Die Erfindung betrifft eine Sensoreinheit gemäß Oberbegriff des Patentanspruches 1.

Ein Stoß, welcher unmittelbar auf die Sensoreinheit bei dem Unfall wirkt, ist weich im Vergleich zu einem abrupten Stoß, welcher unmittelbar auf die Sensoreinheit beim Aufprall nach einem versehentlichen Fallenlassen eines die Sensoreinheit enthaltenden Schaltungsgehäuses auf einen harten Steinboden wirkt. Solche abrupten, harten Stöße treten z.B. während der Fertigung und Endmontage von Schaltungsgehäusen auf, welche neben der Sensoreinheit noch die Auslöseschaltung zur Steuerung eines Kfz-Airbagsystemes aufweisen und der harte Stoß - womoglich zunächst unerkannt - die bruchgefährdete bzw. verformungsgefährdete Sensoranordnung beschädigt.

Aus der DE 33 28 114 A1 ist eine Sensoreinheit zur Steuerung eines Insassenschutzsystems eines Fahrzeugs bekannt, die eine Sensoranordnung mit einer seismischen Masse zum Erkennen einer Beschleunigung sowie eine Sensorkapsel aufweist. Die Sensorkapsel ist mit Öl gefüllt, um Schwingungen eines Biegebalkens der Sensoranordnung zu dämpfen.

Aus der GB 2 084 330 A ist eine Beschleunigungssensoreinheit bekannt, die in einem Flugzeug eingesetzt wird, und die einen Mantel aus Silikongummi enthält.

Aus der US 3 383 565 ist ein Gehäuse zur Aufnahme mehrerer Leiterplatten bekannt, wobei einige der Leiterplatten vertikal angeordnet und mit einer horizontal darüber angeordneten Leiterplatte über Leitungen elektrisch verbunden sind. Die vertikalen Leiterplatten sind bis knapp unter ihren oberen Rand in Silikongummi eingebettet. Ihr oberer Rand, die Leitungen und die horizontale Leiterplatte sind von einer festen Vergußmasse umgeben.

Die Aufgabe, Beschädigungen der Sensoranordnung bei solchen harten Stößen weitgehend zu vermeiden, wird erfindungsgemäß durch den im Patentanspruch 1 definierten Gegenstand gelöst.

Vorteilhafte Weiterbildungen der Erfindung sind in den Unteransprüchen gekennzeichnet.

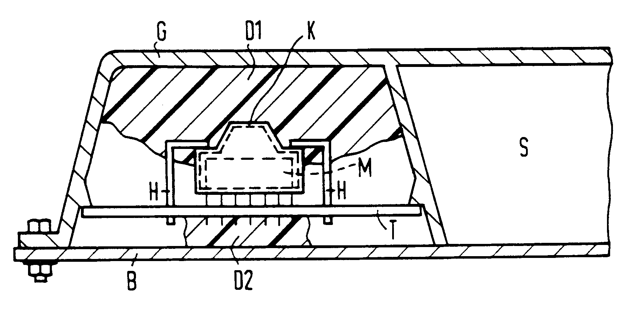

Die Zeichnung zeigt ein Ausführungsbeispiel der Erfindung.

Die einzige Figur der Zeichnung zeigt die Sensoreinheit E, welche hier beispielhaft durch eine gekapselte, nämlich in einer Sensorkapsel K angebrachte, gegen harte Stöße besonders empfindliche Mikromechanik M gebildet wird, die ihrerseits Beschleunigungen und / oder Verzögerungen mittels einer seismischen Masse erfassen kann und dazu besonders bruchempfindliche, zarte Siliziumteile enthält. Die elektrischen Anschlüsse der Sensoreinheit E sind ihrerseits auf einer Leiterplatte T angelötet. Zusätzlich wird zur Versteifung die Sensoreinheit E noch mit einem metallischen hutähnlichen Bügel H gehalten, wobei dieser Bügel H seinerseits ebenfalls an der Leiterplatte T angelötet ist. Die Leiterplatte T zusammen mit dem Bügel H bilden eine Halterung H/T, welche die Sensoreinheit E relativ starr in ihrer Lage zu halten vermag.

Die Leiterplatte ist ihrerseits in einer kleinen Kammer G/B oder Bucht G/B eines z.B. aus Alu-Spritzguß bestehenden Schaltungsgehäuses G/B/S befestigt. Im Teil S - evtl. teilweise auch in der Kammer G/B - ist die Elektronik untergebracht, welche durch die Sensoreinheit E gesteuert wird und bei einem Unfall des Fahrzeuges das Insassenschutzsystem auslösen soll.

Erfindungsgemäß wird die Oberfläche der Sensoreinheit E von einem weichen nachgiebigen Dämpfungselement berührt, das jeweils z.B. einen weitgehend formstabile Asphaltklumpen darstellt, vgl. die Masse D1. Bei dem gezeigten Beispiel sind sogar zwei Dämpfungselemente angebracht, vgl. D1 und D2, die beide die Sensoreinheit E berühren.

Das eine Dämpfungselement D1 berührt im gezeigten Beispiel die Oberseite der Sensorkapsel K der Sensoreinheit E, sowie Teile des im Prinzip ebenfalls vibrierfähigen Bügels H, wobei sich dieses Dämpfungselement D1 zusätzlich gegen den Grund G der Kammer G/B des Schaltungsgehäuse G/B/S abstützt und damit zusätzlich Vibrationen im Metall des Schaltungsgehäuses G/B/S ebenfalls dämpft.

Die andere Sensoreinheit D2 berührt im gezeigten Beispiel nur einen vibrierfähigen Teil T der Halterung H/T der Sensoreinheit E, ohne die Sensoreinheit E selbst zu berühren. Zusätzlich stützt sich dieses andere Dämpfungselement D2 gegen den Boden B der Kammer G/B des Schaltungsgehäuse G/B/S ab, wodurch dieses andere Dämpfungselement D2 zusätzlich Vibrationen im Metall des Bodens B des Schaltungsgehäuses G/B/S dämpft.

Das Dämpfungselement D1/D2 besteht erfindungsgemäß aus einer weichen nachgiebigen Masse, welche Vibrationsenergien dämpft, eben z.B. aus klebrigem, zähen, stark dämpfenden Asphalt, - zumindest enthält das Dämpfungselement erfindungsgemäß eine solche Vibrationen dämpfende Masse. Der Dämpfungselement D1/D2 dämpft bei einem - im Vergleich zu dem Stoß, welcher bei dem Unfall unmittelbar auf die Sensoreinheit E wirkt - harten Stoß die auftretenden mechanischen Erschütterungen der Sensoreinheit E.

So kann sowohl das Dämpfungselement D1 als auch das Dämpfungselement D2 - z.B. beim Aufprall nach einem versehentlichen Fallenlassen des die Sensoreinheit E enthaltenden Schaltungsgehäuses G/B/S auf einen harten Steinplattenboden - die Mikromechanik M vor Bruch schützen, weil das Dämpfungselement D1 bzw. D2 jeweils weitgehend die dabei auftretenden Vibrationsenergien dämpft.

Der Stoß, welcher unmittelbar auf die Sensoreinheit bei dem Unfall wirkt, ist weich im Vergleich zu dem abrupten Stoß, welcher unmittelbar auf die Sensoreinheit beim Aufprall nach einem versehentlichen Fallenlassen der Sensoreinheit oder beim Fallenlassen eines die Sensoreinheit enthaltenden Schaltungsgehäuses wirkt. Der beim Unfall auf die Sensoreinheit E wirkende Stoß wird also praktisch ungedämpft aus die Sensoreinheit E übertragen, so daß diese Stoß bei der Erfindung durch die bruchempfindliche Mikromechanik M gemessen werden kann, - und zwar i.allg. ohne daß dieser Stoß die Mikromechanik M zerstören würde. Das Dämpfungselement dämpft also bevorzugt die hochfrequenten Komponenten der Vibrationen bei einem harten Stoß, aber bevorzugt nicht jene niederfrequenten Komponenten von mechanischen Erschütterungen, welche bei einem Unfall des Fahrzeuges auftreten und für die Elektronik als Anzeige für das Auftreten eines Unfalles dienen.

Die Erfindung gestattet also, jene abrupten, harten Stöße unschädlich zu machen, welche z.B. während des Fertigung und Endmontage von Schaltungsgehäusen auftreten können, z.B. durch versehentliches Fallenlassen des bereits fertig mit der Elektronik und der Sensoreinheit E ausgestatteten Schaltungsgehäuse G/B/S, oder auch durch einen versehentlichen harten Schlag mit einem Werkzeug gegen das bereits in das Fahrzeug eingebaute Schaltungsgehäuse G/B/S. Die Erfindung vermeidet daher auch, daß Schaltungsgehäuse G/B/S versehentlich zusammen mit ihren auf solche Weise beschädigten defekten Sensoreinheiten E in ein Kfz eingebaut werden oder nach dem Einbau - womöglich unerkannterweise - beschädigt werden.

Die Erfindung gestattet, eine breite Vielzahl verschiedenster Massen als Dämpfungselement D1/D2 zu verwenden, so daß man sich - je nach den vorhandenen Fertigungseinrichtungen und je nach den sonstigen Bedürfnissen wie chemische Neutralität - eine optimale Masse aus der Vielzahl der grundsätzlich verwendbaren Massen aussuchen kann. So kann das Dämpfungselement D1/D2 statt einer asphaltartigen Masse z.B. auch Silikon-Gel, mäßig ausgehärtetes Klebermaterial, Kautschuk und / oder Polyurethan enthalten oder völlig aus solchen Massen bestehen.

Wie Versuche zeigten, kann man bereits mit besonders wenig Dämpfungselement-Masse - und damit mit geringen zusätzlichen Gewicht des fertig montierten Schaltungsgehäuses G/B/S - eine deutliche Vorsorge gegen die Gefährdung durch Bruch bzw. durch bleibende Verformungen der Sensoranordnung erreichen, wenn sein Dämpfungselement D1/D2 mindestens 10 % der Oberfläche der Sensoreinheit E berührt.

Macht man aber die berührende Fläche größer als 10 % der Oberfläche der Sensoreinheit E, dann kann man, wie man schon gefühlsmäßig erfassen kann und wie auch Versuche zeigten, eine noch bessere Vorsorge gegen die Zerstörung des Sensoreinheit E erreichen. Besonders wichtig ist dies bei der Verwendung der besonders bruchgefährdeten Mikromechanik M als Sensoranordnung M. So kann man das Dämpfungselement D1 bzw. D2 auch mehr als 50% der Oberfläche der Sensoreinheit E bedecken lassen.

Eine besonders gute Vorsorge gegen die Gefährdung durch Bruch bzw. durch bleibende Verformungen der Sensoranordnung kann man dadurch erreichen, daß das Dämpfungselement D1/D2 - ausschließlich oder zusätzlich - einen im Prinzip beim Stoß vibrierfähigen Teil der Halterung H/T berührt. Bei dem in der Figur gezeigten Beispiel berührt das Dämpfungselement D2 alleine die Leiterplatte T, außerdem das Dämpfungselement D1 nicht nur die Sensorkapsel K sondern auch Teile des Bügels H. Dadurch werden die vom Schaltungsgehäuse G/B/S nach innen zur Sensoreinheit E fließenden Vibrationsenergien schon dann stark gedämpft, wenn sie sich über die Halterung T/H zum Sensoreinheit E hin ausbreiten.

Um die eigentliche Sensoranordnung M vor Verschmutzungen oder vor chemischen Angriffen durch das Dämpfungselement D1/D2 verschonen zu können, ist die Sensoreinheit E - wie beispielhaft in der Figur gezeigt ist - eine Sensorkapsel K enthalten, in welcher die eigentliche, gegen Beschleunigungen und / oder Verzögerungen empfindliche Sensoranordnung M befestigt ist.

Man kann die Vibrationsenergien noch besser dadurch dämpfen, daß die Dämpfungselemente D1/D2 nicht nur oberflächlich die Sensoreinheit E - bzw. unmittelbar deren Sensoranordnung M - bedecken, sondern daß die Dämpfungselemente D1/D2 sich zusätzlich von innen her gegen das äußere Gehäuse abstützen, also zumindest einen Teil eines Raumes zwischen der Sensoreinheit E und einem äußeren Gehäuse G/B ausfüllen. Dann dämpft das Dämpfungselement D1/D2 nämlich jeweils zusätzlich die Vibrationen des äußeren Gehäuses, schon bevor diese sich über die Halterung T/H auf das Sensoreinheit E ausbreiten.

Um - wie bereits in der Figur gezeigt ist - die Sensoreinheit E geschickt in einem Schaltungsgehäuse G/B/S so unterzubringen,
- daß das Schaltungsgehäuse G/B/S die von der Sensoreinheit E gesteuerte Elektronik aufnehmen kann,
- daß die Sensoreinheit E in einer engen eigenen Kammer G/B unter wenig Aufwand für die Dämpfungselement-Masse anzubringen ist und mit wenig zusätzlichen Gewicht erfindungsgemäß gegen die harten Stöße geschützt wird, und
- daß leicht vermieden werden kann, daß die Elektronik selbst durch Dämpfungselement-Massen verschmutzt wird,
kann in dem Schaltungsgehäuse G/B/S eine das äußere Gehäuse G/B bildende Kammer G/B angebracht werden,
- in welcher die Sensoreinheit E befestigt ist und
- deren freier Raum teilweise mit dem Dämpfungselement D1/D2 ausgefüllt ist.

## Patentansprüche

1. Sensoreinheit (E) zur Steuerung eines Insassenschutzsystems eines Fahrzeugs, mit einer Sensoranordnung (M) mit einer seismischen Masse zum Erkennen einer Beschleunigung, und mit einer Sensorkapsel (K), die die Sensoranordnung (M) enthält,
**dadurch gekennzeichnet**.
- daß die Sensoreinheit (E) mit einer Leiterplatte (T) elektrisch leitend und mechanisch relativ starr verbunden ist,
- daß die Leiterplatte (T) in einem Gehäuse (G/B/S) befestigt ist,
- daß der Raum zwischen der Sensorkapsel (K) und dem Gehäuse (G/B) teilweise mit einem nachgiebigen Dämpfungselement (D1/D2) ausgefüllt ist, und
- daß die Sensorkapsel (K) und das Gehäuse (G/B/S) an einem Teil ihrer Oberflächen von dem Dämpfungselement (D1/D2) berührt werden

2. Sensoreinheit (E) nach Patentanspruch 1, dadurch gekennzeichnet, daß das Dämpfungselement (D1/D2) Silikon-Gel enthält oder aus Silikon-Gel besteht.

3. Sensoreinheit (E) nach Patentanspruch 1, dadurch gekennzeichnet, daß das Dämpfungselement (D1/D2) asphaltartige Masse enthält oder aus asphaltartiger Masse besteht.

4. Sensoreinheit (E) nach Patentanspruch 1, dadurch gekennzeichnet, daß das Dämpfungselement (D1/D2) mäßig ausgehärtetes Klebermaterial enthält oder aus einem mäßig ausgehärteten Klebermaterial besteht.

5. Sensoreinheit (E) nach Patentanspruch 1, dadurch gekennzeichnet, daß das Dämpfungselement (D1/D2) Kautschuk enthält oder aus Kautschuk besteht.

6. Sensoreinheit (E) nach Patentanspruch 1, dadurch gekennzeichnet, daß das Dämpfungselement (D1/D2) Polyurethan enthält oder aus Polyurethan besteht.

7. Sensoreinheit (E) nach Patentanspruch 1, dadurch gekennzeichnet, daß das Gehäuse (G/B/S) eine Kammer (G/B) aufweist, die das Dämpfungselement (D1) enthält.

## Claims

1. Sensor unit (E) for controlling a passenger protection system of a vehicle, having a sensor arrangement (M) with a seismic mass for detecting an acceleration, and with a sensor capsule (K) which contains the sensor arrangement (M), characterized
- in that the sensor unit (E) is mechanically relatively rigidly connected to a printed circuit board (T) in an electrically conductive fashion,
- in that the printed circuit board (T) is mounted in a housing (G/B/S),
- in that the space between the sensor capsule (K) and the housing (G/B) is filled partially with a resilient damping element (D1/D2), and
- in that the sensor capsule (K) and the housing (G/B/S) are touched by the damping element (D1/D2) over part of their surfaces.

2. Sensor unit (E) according to Claim 1, characterized in that the damping element (D1/D2) contains silicone gel or consists of silicone gel.

3. Sensor unit (E) according to Claim 1, characterized in that the damping element (D1/D2) contains asphalt-like material or consists of asphalt-like material.

4. Sensor unit (E) according to Claim 1, characterized in that the damping element (D1/D2) contains moderately cured adhesive material or consists of a moderately cured adhesive material.

5. Sensor unit (E) according to Claim 1, characterized in that the damping element (D1/D2) contains rubber or consists of rubber.

6. Sensor unit (E) according to Claim 1, characterized in that the damping element (D1/D2) contains polyurethane or consists of polyurethane.

7. Sensor unit (E) according to Claim 1, characterized in that the housing (G/B/S) has a chamber (G/B) which contains the damping element (D1).

## Revendications

1. Bloc détecteur (E) pour commander un système de protection de passager d'un véhicule, comportant un dispositif détecteur (M) ayant une masse sismique destinée à détecter une accélération et une capsule détectrice (K) qui contient le dispositif détecteur (M),
caractérisé
- en ce que le bloc détecteur (E) est relié à une plaque de circuit imprimé (T) de façon à conduire l'électricité et avec une liaison mécanique relativement rigide,
- en ce que la plaque de circuit imprimé (T) est fixée dans un boîtier (G/B/S),
- en ce que l'espace compris entre le bloc détecteur (E) et le boîtier (G/B) est partiellement rempli par un élément amortisseur (D1/D2) déformable, et
- en ce que la capsule détectrice et le boîtier (G/B/S) sont en contact, sur une partie de leur surface externe, avec l'élément amortisseur (D1/D2).

2. Bloc détecteur (E) suivant la revendication 1, caractérisé en ce que l'élément amortisseur (D1/D2) contient un gel aux silicones ou est constitué d'un gel aux silicones.

3. Bloc détecteur (E) suivant la revendication 1, caractérisé en ce que l'élément amortisseur (D1/D2) contient une masse du genre asphalte, ou est constitué d'une masse du genre asphalte.

4. Bloc détecteur (E) suivant la revendication 1, caractérisé en ce que l'élément amortisseur (D1/D2) contient une colle, durcie dans la masse, ou est constitué d'une colle, durcie dans la masse.

5. Bloc détecteur (E) suivant la revendication 1, caractérisé en ce que l'élément amortisseur (D1/D2) contient du caoutchouc, ou est constitué de caoutchouc.

6. Bloc détecteur (E) suivant la revendication 1, caractérisé en ce que l'élément amortisseur (D1/D2) contient du polyuréthanne, ou est constitué de polyuréthanne.

7. Bloc détecteur (E) suivant la revendication 1, caractérisé en ce que le boîtier (G/B/S) comporte une chambre (G/B) qui contient l'élément amortisseur (D1).
